## Europäisches Patentamt

(19) **European Patent Office**

**Office européen des brevets**

(11) Veröffentlichungsnummer: **0 085 727**
**B1**

(12) # EUROPÄISCHE PATENTSCHRIFT

(45) Veröffentlichungstag der Patentschrift:
30.04.86

(51) Int. Cl.⁴: **H 03 K 5/24, G 11 C 7/00**

(21) Anmeldenummer: **82100870.3**

(22) Anmeldetag: **06.02.82**

(54) Integrierte Komparatorschaltung.

(43) Veröffentlichungstag der Anmeldung:
17.08.83 Patentblatt 83/33

(45) Bekanntmachung des Hinweises auf die Patenterteilung:
30.04.86 Patentblatt 86/18

(84) Benannte Vertragsstaaten:
**DE FR GB IT NL**

(56) Entgegenhaltungen:
DE - A - 3 021 678
US - A - 4 079 332

(73) Patentinhaber: **Deutsche ITT Industries GmbH,
Hans-Bunte-Strasse 19 Postfach 840, D-7800 Freiburg
(DE)**

(84) Benannte Vertragsstaaten: **DE**

(73) Patentinhaber: **ITT INDUSTRIES INC., 320 Park Avenue,
New York, NY 10022 (US)**

(84) Benannte Vertragsstaaten: **FR GB IT NL**

(72) Erfinder: **Neal, Mathew, Dipl.-Ing., Innsbrucker
Strasse 50, D-7800 Freiburg I. Br. (DE)**
Erfinder: **Reimers, Jochen, Dipl.-Ing., Belchenstrasse 20,
D-7803 Gundelfingen (DE)**

(74) Vertreter: **Morstadt, Volker, Dipl.-Ing. et al, c/o Deutsche
ITT Industries GmbH Patent/Lizenzabteilung
Postfach 840 Hans-Bunte-Strasse 19,
D-7800 Freiburg/Brsg. (DE)**

**Beschreibung**

Die Erfindung betrifft eine integrierte Komparatorschaltung mit Isolierschicht-Feldeffekttransistoren gleichen Leitungstyps, die aus einer beliebigen Potentialdifferenz an zwei Eingängen min Ausgangssignal mit einem möglichst dem Potential des Schaltungsnullpunkts entsprechenden Low-Zustand bzw. einem möglichst dem Potential der Betriebsspannungsquelle entsprechenden High-Zustand erzeugt.

Derartige Komparatorschaltungen können beispielsweise als sogenannte Leseverstärker für Speicherschaltungen mit statischen Speicherzellen, z.B. nach dem Flipflop-Prinzip,; verwendet werden.Die an den beiden Ausgängen derartiger Speicherzellen auftretende Potentialdifferenz, die gleich der Spannungsdifferenz zwischen dem High-Zustand am einen Ausgang und dem Low-Zustand am anderen Ausgang und umgekehrt ist, soll dabei so abgegriffen, bzw. "gelesen" werden, daß am Ausgang der Komparatorschaltung ein möglichst großer Abstand zwischen High-Zustand und Low-Zustand an diesem Ausgang auftritt, d.h. daß die beiden Zustände jeweils möglichst nahe dem Potential des Schaltungsnullpunkts bzw. dem der Betriebsspannung liegen. Außerdem soll die Schaltung schon auf kleine Potentialdifferenzen am Eingang sicher ansprechen, d.h. die Empfindlichkeit der Schaltung im Bereich der Potentialdifferenz Null am Dingang soll möglichst groß sein, wo durch die Ansprechgeschwindigkeit merklich erhöht wird.

Schließlich soll eine derartige Komparatorschaltung einen geringen Stromverbrauch haben und bei der Herstellung als Teil einer umfassenden integrierten Schaltung, beispielsweise als Teil einer Speichermatrix, gegenüber Herstellungsprozeß-Parameterschwankungen möglichst unempfindlich sein und wenig Fläche beanspruchen.

Aus der DE-A1-30 21 678 ist eine integrierte lineare Differenzverstärkerschaltung mit Isolierschicht-Feldeffekttransistoren gleichen Leitungstyps bekannt, die aus einer beliebigen Potentialdifferenz an zwei Eingängen an einem Ausgang ein Ausgangssignal mit einem möglichst dem Potential des Schaltungsnullpunktes gleichen Low-Zustand bzw. einem möglichst dem Potential der Betriebsspannungsquelle gleichen High-Zustand erzeugt. Bei dieser Differenzverstärkerschaltung liegen zwischen der Betriebspannungquelle und dem Schaltungspunkt vier Reihenschaltungen von gesteuerten Strompfaden jeweils dreier Transistoren, von denen die an der Betriebsspannungsquelle liegenden Transistoren, die oberen Transistoren und die mittleren Transistoren vom Verarmungstyp und voneinander gleichen geometrischen Abmessungen und die am Schaltungsnullpunkt liegenden Transistoren, die unteren Transistoren vom Anreicherungstyp und von untereinander identischen geometrischen Abmessungen sind. Der Eingang jeder der Reihenschaltungen ist ferner das Gate des einen der Transistoren des Verarmungstyps und der Ausgang der Reihenschaltung der jeweilige Verbindungspunkt von mittlerem und unterem Transistor. Der Ausgang der vierten Reihenschaltung ist schließlich der Ausgang der Komparatorschaltung.

Obwohl diese lineare Differenzverstärkerschaltung als Komparator für eine digitale Anwendung kaum geeignet ist, wird bei der Erfindung von der bekannten linearen Differenzverstärkerschaltung ausgegangen.

Die Erfindung betrifft somit eine integrierte Komparatorschaltung gemäß dem Oberbegriff des Anspruchs.

Aufgabe der im Anspruch gekennzeichneten Erfindung ist die Angabe einer Komparatorschaltung mit möglichst großer Empfindlichkeit im Bereich der Potentialdifferenz Null am Eingang.

Aus der US-PS 40 79 332 ist zwar bekannt, die Verstärkung eines Differenzverstärkers mit zwei Ausgängen mittels Rückkopplung von einem Ausgang auf die Gateelektrode eines Transistors zu erhöhen, welcher den gemeinsamen unteren Schaltungspunkt einer Parallelschaltung zweier Serienschaltungen je eines Transistors vom Anreicherungstyp mit einem Transistor vom Verarmungstyp mit dem Schaltungsnullpunkt verbindet. Bei der integrierten Komparatorschaltung nach der Erfindung wird zwar auch eine Rückkopplung angewendet, jedoch nicht unmittelbar vom Ausgang des Komparators, sondern in besonderer Weise zur Lösung der der Erfindung zugrundeliegenden Aufgabe.

Die mittleren Transistoren m1, m3, m4 der ersten, dritten und vierten Reihenschaltung s1, s3, s4 sind dadurch als Widerstand geschaltet, daß ihr Gate am Verbindungspunkt mit dem zugehörigen oberen Transistor angeschlossen ist. Das Gate des mittleren Transistors m2 der zweiten Reihenschaltung s2 liegt am Verbindungspunkt von oberem und mittlerem Transistor o4, m4 der vierten Reihenschaltung s4, wodurch eine Rückkopplung innerhalb der Komparatorschaltung gegeben ist.

Das Gate des unteren Transistors u1 der ersten Reihenschaltung s1 liegt an deren Ausgang, an dem auch das Gate des unteren Transistors u2 der zweiten Reihenschaltung s2 angeschlossen ist. In vergleichbarer Weise liegen das Gate des unteren Transistors u3 bzw. das des unteren Transistors u4 der dritten bzw. der vierten Reihenschaltung s3, s4 am Ausgang der zweiten Reihenschaltung s2 bzw. an dem der dritten Reihenschaltung s3. Schließlich ist der Ausgang der vierten Reihenschaltung s4 der Ausgang a der Komparatorschaltung.

Im Betrieb wirken die oberen Transistoren o1...o4 als spannungsgesteuerte Widerstände. Die erste Reihenschaltung s1 bildet mit der zweiten Reihenschaltung s2 eine Stromspiegelschaltung bezüglich des jeweiligen Stromes in der Reihenschaltung, wobei der Strom vom Potential am Eingang e1 bestimmt ist.

Im Bereich der Potentialdifferenz Null an den beiden Eingängen e1,e2 nehmen die Ausgänge der vier Reihenschaltungen jeweils das gleiche Potential an,so daß die von den vier Reihenschaltungen s1...s4 jeweils gebildeten Inverter ihre größte Steilheit aufweisen.

Es sei nun angenommen, daß die Potentialdifferenz u in Richtung vom ersten zum zweiten Eingang e1, e2 in positivem Sinn von null abweicht. Dann werden die oberen Transistoren o1, o3 niederohmiger und die oberen Transistoren o2, o4 hochohmiger, so daß der in den unteren Transistoren u1, u2 fließende Strom größer wird. Somit nimmt die Ausgangsspannung der zweiten und der vierten Reihenschaltung s2, s4 ab und die der dritten Reihenschaltung s3 wird größer. Zugleich sinkt die Spannung am Gate des mittleren Transistors m2, was das Absinken der Ausgangsspannung der zweiten Reihenschaltung s2 unterstützt. Somit ergibt sich ein schnelles Durchschalten der Anordnung, so daß die Komparatorschaltung zusätzlich zur guten Ansprechempfindlichkeit auch eine sehr gute Ansprechgeschwindigkeit aufweist.

Eine realisierte Komparatorschaltung entsprechend der Erfindung konnte bei einem statischen Speicher mit freiem Zugriff verwendet werden, der mit einer Taktfrequenz von 17 MHz betrieben wurde, und war in der Lage, mit dieser Frequenz erfolgende Speicherzustandswechsel zu "lesen".

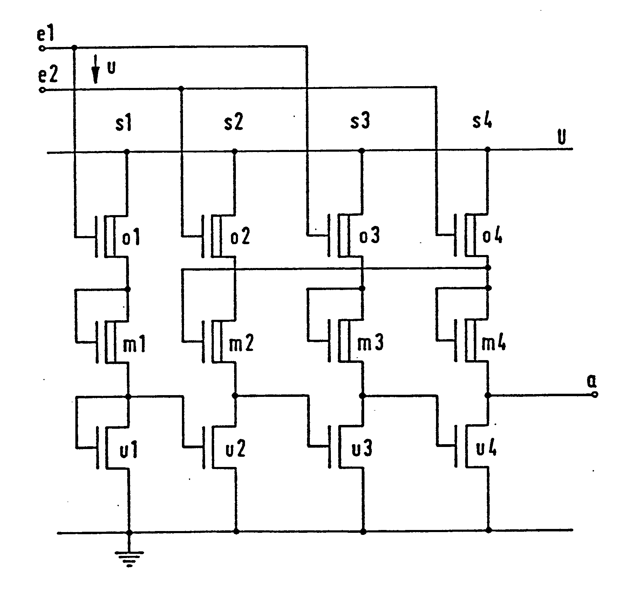

**Patentanspruch**

1. Integrierte Komparatorschaltung mit Isolierschicht-Feldeffekttranstoren gleichen Leitungstyps, die aus einer beliebigen Potentialdifferenz an zwei Eingängen (e1, e2) an einem Ausgang ein Ausgangssignal mit einem müglichst dem Potential des Schaltungsnullpunkts gleichen Low-Zustand bzw. einem möglichst dem Potential der Betriebsspannungsquelle (U) gleichen High-Zustand erzeugt, bei welcher Komparatorschaltung

- zwischen der Betriebsspannungsquelle (U) und dem Schaltungsnullpunkt vier Reihenschaltungen (s1...s4) von gesteuerten Strompfaden jeweils dreier Transistoren liegen, von den die an der Betriebsspannungsquelle liegenden Transistoren (= "obere Transistoren") (o1...o4) und die mittleren Transistoren (m1...m4) vom Verarmungstyp und von untereinander gleichen geometrischen Abmessungen und die am Schaltungsnullpunkt liegenden Transistoren (= "untere Transistoren") (n1...n4) vom Anreicherungstyp und von untereinander identischen geometrischen Abmessungen sind,

- der Eingang jeder Reihenschaltung das Gate des einen der Transistoren des Verarmungstyps und der Ausgang jeder Reihenschaltung der jeweilige Verbindungspunkt von mittlerem und unterem Transistor ist,

- das Gate des unteren Transistors der ersten Reihenschaltung mit deren Ausgang und das Gate des jeweils unteren Transistors der zweiten, drittem bzw. vierten Reihenschaltung am jeweiligen Ausgang der ersten, zweiten bzw. dritten Reihenschaltung liegen,

- der erste Eingang der Komparatorschaltung mit den Eingängen der ersten und der dritten und der zweite Eingang der Komparatorschaltung mit den Eingängen der zweiten und der vierten Reihenschaltung verbunden sind und

- der Ausgang der vierten Reihenschaltung der Ausgang der Komparatorschaltung ist,
  <u>dadurch gekennzeichnet,</u>

- daß der erste Eingang (e1) der Komparatorschaltung an den Gates der oberen Transistoren (o1, o3) der ersten und der dritten Reihenschaltung (s1, s3) liegt, während der zweite Eingang (e2) der Komparatorschaltung an den Gates der oberen Transistoren (o2, o4) der zweiten und der vierten Reihenschaltung (s2, s4) liegt,

- daß bei den mittleren Transistoren (m1, m3, m4) der ersten, dritten bzw. vierten Reihenschaltung (s1, s3, s4) jeweils das Gate am Verbindungspunkt mit dem jeweils oberen Transistor (o1, o3, o4) angeschlossen ist und

- daß das Gate des mittleren Transistors (m2) der zweiten Reihenschaltung (s2) am Verbindungspunkt von oberem und mittlerem Transistor (o4, m4) der vierten Reihenschaltung (s4) liegt.

**Claim**

1. Integrated comparator circuit employing insulated-gate field-effect transistors of the same conductivity type, which, from any arbitrary potential difference at two inputs (e1, e2) produces at one output an output signal with either a low-level state possibly corresponding to the potential of the zero point of the circuit, or a high-level state possibly corresponding to the potential of the source of operating voltage (U), in which comparator circuit

- between the source of operating voltage (U) and the zero point of the circuit there are four series arrangements (s1...s4) of controlled current paths of each time three transistors of which the transistors connected to the source of operating voltage (= "upper transistors") (o1...04) and the center transistors (m1...m4) are of the depletion type and have the same geometrical dimensions among each other, while the transistors connected to the zero point of the circuit (= "lower transistors") (u1...u4) are of the enhancement type and have identical geometrical dimensions among each other,

- the input of each series arrangement is the gate of one of the depletion-type transistors, and the output of each series arrangement is the respective point connecting both the center and the lower transistor,

- the gate of the lower transistor of the first series arrangement is connected to the output thereof, and the gate of the respective lower transistor of the second, third or fourth series arrangement is connected to the respective output of the first, second or third series arrangement,

- the first input of said comparator circuit is connected to the inputs of both the first and the third series arrangement, while the second input of said comparator circuit is connected to the inputs of both the second and the fourth series arrangement, and

- the output of the fourth series arrangement is the output of the comparator circuit,

    characterized in
- that the first input (e1) of the comparator circuit is connected to the gates of the upper transistors (01, 03) of both the first and the third series arrangement (s1, s3), while the second input (e2) of the comparator circuit is connected to the gates of the upper transistors (02, 04) of both the second and the fourth series arrangement,

- that with respect to the center transistors (m1, m3, m4) of the first, third or fourth series arrangements (s1, s3, s4) respectively, the gates are connected to the point connecting the respective upper transistors (01, 03, 04), and

- that the gate of the center transistor (m2) of the second series arrangement (s2) is connected to the point connecting both the upper and the center transistors (04, m4) of the fourth series arrangement (s4).


**Revendication**

1. Circuit comparateur intégré employant des transistors à effet de champ à grille isolée d'un même type de conductibilité pour produire, à partir d'une différence de potentiel arbitraire sur deux entrées (e1, e2), un signal de sortie ayant soit un niveau bas, correspondant éventuellement au potentiel du point zéro du circuit, soit un niveau haut, correspondant éventuellement au potentiel de la source de tension d'alimentation, dans lequel:

- entre la source de tension d'alimentation (U) et le point zéro du circuit, il est prévu quatre arrangements en série (s1...,s4) des trajets de courant commandé de trois transistors, à chaque fois, dont les transistors connectés à la source de tension d'alimentation (transistors supérieurs) (o1...,o4)et les transistors centraux (m1...,m4) sont du type à appauvrissement et ont entre eux les mêmes dimensions géométriques, tandis que les transistors connectés au point zéro du circuit (transistors inférieurs) (u1...,u4) sont du type à enrichissement et ont entre eux des dimensions géométriques identiques,

- l'entrée de chaque arrangement en série est la grille de chacun des transistors à appauvrissement et la sortie de chaque arrangement en série est le point de connexion respectif entre le transistor central et le transistor inférieur,

- la grille du transistor inférieur du premier arrangement en série est connectée à la sortie de celui-ci et la grille de chacun des transistors inférieurs des deuxième, troisième, quatrième arrangements en série est connectée respectivement à la sortie des premier, deuxième, troisième arrangement en série,

- la première entrée du circuit comparateur est connectée aux entrées des premier et troisième arrangements en série et la deuxième entrée du circuit comparateur est connectée aux entrées des deuxième et quatrieme arrangements en série et

- la sortie du quatrième arrangement en série est la sortie du circuit comparateur,

    caractérisé en ce que:
- la première entrée (el) du circuit comparateur est connectée aux grilles des transistors supérieurs (ol, o3) du premier et du troisième arrangements en série (sl, s3), alors que la deuxième entrée (e2) du circuit comparateur est connectée aux grilles des transistors supérieurs (o2, o4) des deuxième et quatrième arrangements en série (s2, s4),

- les transistors centraux (ml, m3, m4) des premier, troisième et quatrième arrangements en série (sl, s3, s4) ont chacun leur grille connectée à leur point de raccordement au transistor supérieur respectif (o1, o3, o4) et

- la grille du transistor central (m2) du deuxième arrangement en série (s2) est connectée au point de raccordement du transistor supérieur au transistor central (o4, m4) du quatrième arrangement en série (s4).